# EUROPÄISCHE PATENTSCHRIFT

(11) **EP 0 941 641 B1**
(45) Veröffentlichungstag und Bekanntmachung des Hinweises auf die Patenterteilung: **13.12.2000**
(21) Anmeldenummer: 97910235.7
(22) Anmeldetag: 30.09.1997
(51) Int. Cl.: H05K 5/00, H05K 5/06, H05K 9/00

(54) **ELEKTRISCH LEITFÄHIGES GEHÄUSE FÜR EIN ELEKTRISCHES GERÄT**
ELECTROCONDUCTIVE HOUSING FOR AN ELECTRIC APPLIANCE
BOITIER ELECTROCONDUCTEUR POUR APPAREIL ELECTRIQUE

(30) Priorität: 29.11.1996 DE 19649516
(43) Veröffentlichungstag der Anmeldung: 15.09.1999
(73) Patentinhaber: ROBERT BOSCH GMBH, 70442 Stuttgart (DE)
(72) Erfinder: KAISER, Harry, D-71706 Markgroeningen (DE)
(86) Internationale Anmeldenummer: DE9702243
(87) Internationale Veröffentlichungsnummer: WO9824280

(56) Entgegenhaltungen:
- EP-A- 0 540 071
- DE-U- 9 304 485
- DE-U- 29 707 528
- FR-A- 2 655 809
- GB-A- 2 177 265
- US-A- 4 337 444
- US-A- 4 431 113

## Beschreibung

### Stand der Technik

Die Erfindung geht aus von einem elektrisch leitfähigen Gehäuse nach der Gattung des Patentanspruchs 1.

Bei einem auf dem Markt befindlichen Gehäuse ist in diesem ein in einem Kraftfahrzeug zu verwendender elektronischer Sensor angeordnet. An die elektromagnetische Verträglichkeit dieses Sensors mit anderen elektrischen oder elektronischen Systemen des Kraftfahrzeugs sowie mit dessen elektromagnetischer Umwelt werden daher hohe Anforderungen gestellt. Daneben muß der Sensor mittels des Gehäuses vor Umwelteinflüssen wie Feuchtigkeit und Feststoffpartikeln zuverlässig geschützt werden.

Das bekannte Gehäuse und sein Deckel bestehen aus Aluminium-Druckgußteilen. Das Gehäuse weist eine umlaufende Nut auf, in welche der Deckel eingreift. Vor dem Fügen des Deckels wird diese Nut mit Silikonkautschuk gefüllt. An mehreren Punkten des Gehäuses sind die beiden Gehäuseteile durch Niete gegeneinander ausgerichtet und miteinander verbunden. Eine während des Fügens des Deckels den Luftaustausch zulassende Deckelöffnung ist ebenfalls mit Silikonkautschuk verschlossen. Diese bekannte Ausführungsform erfüllt zwar die genannten Anforderungen, sie ist jedoch sehr kostenaufwendig hinsichtlich der Deckelgestaltung und der Montage.

Aus US-A-4 337 444 ist ein gemäß der Gattung des Patentanspruchs 1 ausgebildetes, quaderförmiges Gehäuse aus Metallformteilen zur elektromagnetischen Abschirmung einer elektrischen Schaltung im Gehäuse bekannt. Ein Deckel des Gehäuses weist an zwei benachbarten Rändern rechtwinklig zur Deckelebene hervorstehende, zungenförmige Vorsprünge auf, welche Seitenwände des Gehäuses umfassen. Außerdem ist das Gehäuse am freien Rand von zwei gegenüberliegenden Seitenwänden mit je zwei Blechzungen versehen, welche Schlitze des Deckels durchgreifen. Eine Selbstsicherung des Deckels am Gehäuse ist hierdurch nicht erzielt. Der Deckel findet einen Halt am Gehäuse nur dadurch, daß die Blechzungen endseitig, z. B. durch Löten an einer Schaltungsplatine befestigt sind.

Aus US-A-4 431 113 ist dagegen ein Gehäuse mit rechtwinklig zu einem ebenen Deckel verlaufenden geraden Seitenwänden bekannt, welche nahe ihrem deckelseitigen Rand außen mit jeweils einer sich parallel zum Rand erstreckenden Nut ausgebildet sind. Der Deckel ist im Bereich jeder mit einer Nut versehenen Seitenwand mit einer sich rechtwinklig zur Deckelebene erstreckenden Wandung versehen, welche in geringem Abstand außen neben der Seitenwand verläuft. In der jeweiligen Wandung sind federnde Zungen freigestanzt, die hakenförmig in die zugeordnete Nut der Seitenwand eingreifen und das Abheben des auf das Gehäuse aufgesetzten Deckels verhindern. Von wesentlichem Nachteil der bekannten Ausführungsform ist jedoch, daß die Zungen bei dem Aufsetzen des Deckels auf das Gehäuse bis in die Ebene der Wandung zurückgedrängt werden müssen, bevor sie in die eine Hinterschneidung bildende Nut der jeweiligen Seitenwand einspreizen können. Außerdem verteuern die Hinterschneidungen die Herstellung des Gehäuses.

Schließlich ist es aus FR-A-2 655 809 bekannt, Nuten von Gehäuseteilen, an denen diese ineinandergreifen, mit einer Dichtmasse auszufüllen.

### Vorteile der Erfindung

Das erfindungsgemäße Gehäuse mit den kennzeichnenden Merkmalen des Patentanspruchs 1 hat demgegenüber den Vorteil, daß das Blechformteil erheblich kostengünstiger als ein Gußteil herstellbar und ohne die Notwendigkeit von Niet- oder sonstiger Verbindungen mit dem Gehäuse kraft- und/oder formschlüssig verbindbar ist. Darüber hinaus wird die Schirmwirkung des Gehäuses hinsichtlich magnetischer Felder durch die Verwendung von Stahl für den Deckel verbessert. Außerdem wird durch den Eingriff der Vorsprünge des Deckels in die Nut des Gehäuses ein die Vorsprünge wenig beanspruchendes Fügen des Deckels am Gehäuse erzielt. Ein Gehäuse mit einer gegen den Deckel offene Nut ist relativ einfach zu fertigen. Schließlich ist nur mit den Vorsprüngen des Deckels eine Lagezuordnung des Deckels zum Gehäuse erzielt.

Durch die in den Unteransprüchen aufgeführten Maßnahmen sind vorteilhafte Weiterbildungen und Verbesserungen des im Patentanspruch 1 angegebenen Gehäuses möglich.

Die im Anspruch 2 offenbarte Ausgestaltung des Deckels verbessert seine Zentrierung gegenüber dem Gehäuse, erhöht die Festigkeit der Verbindung zwischen Deckel und Gehäuse und fördert die Schirmwirkung des Gehäuses durch die Kontaktierung mit dem Deckel an möglichst vielen Stellen des Deckelumfangs.

Mit der Maßnahme in Anspruch 3 wird der Montagevorgang des Deckels am Gehäuse erleichtert.

Mit der im Anspruch 4 beschriebenen Formgebung der Vorsprünge am Deckel wird dessen Verankerung aufgrund des "Verkrallens" der Vorsprünge am Wandabschnitt des Gehäuses verbessert.

Die Maßnahme nach Anspruch 5 ist vorteilhaft, weil sie neben der Abdichtung des Gehäuses als zusätzlicher Schutz gegen Lösen des Deckels dient.

### Zeichnung

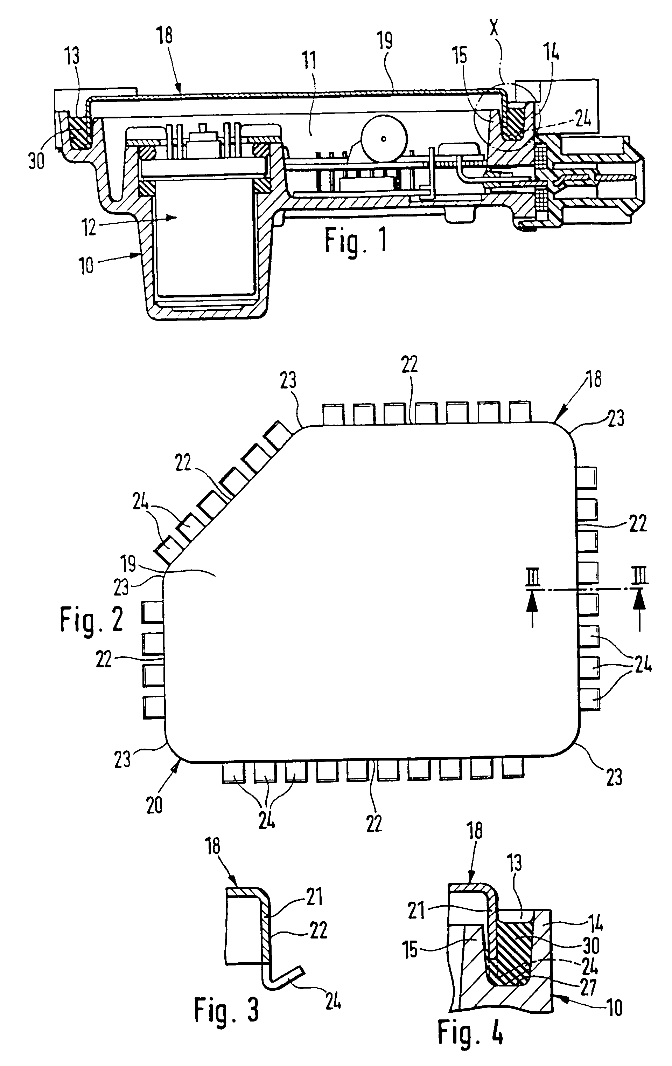

Ein Ausführungsbeispiel der Erfindung ist in der Zeichnung vereinfacht dargestellt und in der nachfolgenden Beschreibung näher erläutert. Es zeigen Figur 1 einen Schnitt durch ein einen Sensor enthaltendes Gehäuse mit einem Deckel, Figur 2 eine Draufsicht auf den Deckel, Figur 3 einen Schnitt entlang der Linie III-III in Figur 2 in vergrößertem Maßstab durch den Rand des Deckels und Figur 4 als Detail eine vergrößerte Wiedergabe des Bereichs X in Figur 1.

### Beschreibung des Ausführungsbeispiels

Ein in Figur 1 mit 10 bezeichnetes Gehäuse ist als Aluminium-Druckgußteil ausgebildet. In seinem Innenraum 11 ist als elektrisches Gerät ein in einem Kraftfahrzeug zu verwendender Sensor 12 angeordnet. Das Gehäuse 10 besitzt randseitig eine umlaufende Nut 13, welche von zwei etwa parallel zueinander verlaufenden Wandabschnitten 14, 15 des Gehäuses gebildet und ebenso wie der Innenraum 11 zur gleichen Gehäuseseite offen ist.

Der Innenraum 11 des Gehäuses 10 ist durch einen schalenförmigen Deckel 18 verschlossen (Figur 2). Der Deckel ist als Stahlblechformteil mit einem ebenen Boden 19 ausgebildet, an den sich als Rand 20 des Deckels eine umlaufende, sich rechtwinklig zur Deckelebene erstreckende Wandung 21 anschließt (Figur 3). Die Wandung 21 des Deckelrandes 20 weist gerade Abschnitte 22 auf, die durch gekrümmte Abschnitte 23 mit relativ kleinem Krümmungsradius verbunden sind. Die geraden Abschnitte 22 des Deckels sind mit einer Vielzahl von in gleichem Abstand angeordneten zungenförmigen Vorsprüngen 24 versehen. Die Vorsprünge 24 sind parallel begrenzt; sie gehen auf der bodenabgewandten Seite des Deckels 18 von der Wandung 21 des Deckelrandes 20 aus. Die Vorsprünge 24 verlaufen zunächst in der Ebene des geraden Wandungsabschnitts 22 und erstrecken sich nach einer Krümmung aus der genannten Ebene zur Deckelaußenseite hinaus, wo sie stumpf enden. Wie Figur 3 erkennen läßt, sind also die Vorsprünge 24 hakenförmig ausgebildet und schließen einen spitzen Winkel zur Ebene des Wandungsabschnitts 22 ein.

Während die geraden Abschnitte 22 des Deckels 18, wie beschrieben, mit den zungenförmigen Vorsprüngen 24 versehen sind, bleiben die gekrümmten Abschnitte 23 aufgrund ihres relativ kleinen Radius vorsprungsfrei. Bei einem Deckel 18 mit weniger stark gekrümmten Abschnitten 23 oder bei einem runden Deckel sind auch diese Abschnitte vorzugsweise mit den beschriebenen Vorsprüngen 24 versehen, das heißt der Deckel 18 weist entlang seinem gesamten Rand zungenförmige Vorsprünge 24 auf.

Beim Fügen des Deckels 18 auf das Gehäuse 10 greift der Rand 20 mit den Vorsprüngen 24 in die Gehäusenut 13 ein (Figur 4). Dabei gelangen die Vorsprünge 24, welche entgegen der Fügerichtung des Deckels 18 zurückweichen, in Kontakt mit dem rechtwinklig zur Deckelebene verlaufenden äußeren Wandabschnitt 14 des Gehäuses 10. Der sich hierdurch selbstzentrierende Deckel 18 nimmt seine Endstellung ein, wenn die Vorsprünge 24 am Nutgrund 27 anschlagen. Dabei graben sich die endseitig scharfkantig begrenzten Vorsprünge 24 aufgrund ihrer Vorspannung in den Wandabschnitt 14 des Gehäuses 10 ein. Der Deckel 18 und das Gehäuse 10, welche beide aus elektrisch leitenden Werkstoffen bestehen, sind daher elektrisch leitfähig miteinander verbunden. Außerdem ist der Deckel 18 durch den Angriff der Vorsprünge 24 am Wandabschnitt 14 gegen Lösen gesichert.

Der Deckel 18 und das Gehäuse 10, welche randseitig ineinander greifen, sind ferner durch eine Dichtmasse 30 aus Silikonkautschuk miteinander verbunden, der nach dem Fügen des Deckels in die Gehäusenut 13 eingebracht ist. Die Dichtmasse 30 benetzt den äußeren Wandabschnitt 14 des Gehäuses 10, den Nutgrund 27, die Vorsprünge 24 und die Außenseite der Wandung 21 des Deckelrandes 20 sowie ferner zu einem kleineren Teil zwischen den Vorsprüngen 24 hindurch auch den inneren Wandabschnitt 15 des Gehäuses 10. Da die Dichtmasse 30 nach dem Fügen des Deckels 18 in die Gehäusenut 13 eingebracht wird, ist eine zusätzliche Entlüftungsbohrung des Deckels nicht erforderlich. Aufgrund der relativ großen freien Oberfläche der Dichtmasse 30 wird deren dem Aushärten dienende Reaktion mit Luft bzw. mit in dieser enthaltenen Feuchtigkeit beschleunigt.

## Patentansprüche

1. Elektrisch leitfähiges Gehäuse (10) für ein elektrisches Gerät (12), insbesondere für einen Sensor in einem Kraftfahrzeug, mit einem Deckel (18) aus einem Metallblechformteil, der das Gehäuse (10) verschließt und mittels an seinem Rand (20) wenigstens abschnittsweise ausgebildeten, aus der Ebene des Deckels (18) hervorstehenden zungenförmigen Vorsprüngen (24), welche endseitig an einem wenigstens annähernd rechtwinklig zur Deckelebene verlaufenden Wandabschnitt (14) des Gehäuses (10) angreifen, mit diesem elektrisch leitend verbunden ist, wobei Deckel (18) und Gehäuse (10) randseitig ineinander greifen,
dadurch gekennzeichnet,
daß der Deckel (18) aus einem Stahlblechformteil besteht und an gegenüberliegenden Abschnitten (22) seines Randes (20) mit den Vorsprüngen (24) versehen ist, welche hakenförmig ausgebildet sind und in eine deckelseitig offene Nut (13) U-förmigen Querschnitts des Gehäuses (10) eingreifen, wobei die Vorsprünge (24) am Grund (27) der Nut (13) abgestützt sind und endseitig an einem die Nut (13) seitig begrenzenden Wandabschnitt (14) des Gehäuses (10) selbstsichernd angreifen.

2. Gehäuse nach Anspruch 1, dadurch gekennzeichnet, daß die Nut (13) des Gehäuses (10) an diesem umlaufend ausgebildet ist und die Vorsprünge (24) des Deckels (18) vorzugsweise entlang dessen gesamtem Rand (20), wenigstens jedoch an geraden Abschnitten (22) des Randes (20) angeordnet sind.

3. Gehäuse nach Anspruch 1, dadurch gekennzeichnet, daß die hakenförmig ausgebildeten Vorsprünge (24) des Deckels (18) entgegen der Fügerichtung des Deckels (18) zurückweichen.

4. Gehäuse nach Anspruch 1, dadurch gekennzeichnet, daß die Vorsprünge (24) endseitig scharfkantig ausgebildet sind und sich aufgrund ihrer Vorspannung in den Wandabschnitt (14) des Gehäuses (10) eingraben.

5. Gehäuse nach Anspruch 1, dadurch gekennzeichnet, daß der Deckel (18) mit seinem Rand (20) und den Vorsprüngen (24) in eine Gehäusenut (13) eingreift, die mit einer Dichtmasse (30) gefüllt ist.

## Claims

1. Electroconductive housing (10) for an electrical device (12), in particular for a sensor in a motor vehicle, having a lid (18) which is made of a sheet-metal formed part, closes the housing (10) and is connected to the latter in a electroconductive manner by means of tongue-shaped projections (24) which are formed at least in sections on the margin (20) of the housing (10), project from the plane of the lid (18) and act at the end on a wall section (14), running at least approximately at right angles to the lid plane, of the housing (10), the lid (18) and housing (10) interlocking at the margin, characterized in that the lid (18) consists of a sheet-steel formed part and is provided with the projections (24) at opposite sections (22) of its margin (20), and these projections (24) are of hook-shaped design and engage in a groove (13) of the housing (10), the groove (13) being open on the lid side and having a U-shaped cross section, the projections (24) being supported on the root (27) of the groove (13) and acting at the end in a self-locking manner on a wall section (14), laterally defining the groove (13), of the housing (10).

2. Housing according to Claim 1, characterized in that the groove (13) of the housing (10) is formed on the housing (10) so as to encircle the same, and the projections (24) of the lid (18) are preferably arranged along its entire margin (20), but at least on straight sections (22) of the margin (20).

3. Housing according to Claim 1, characterized in that the hook-shaped projections (24) of the lid (18) give way against the joining direction of the lid (18).

4. Housing according to Claim 1, characterized in that the projections (24) are designed to be sharp-edged at the end and dig into the wall section (14) of the housing (10) on account of their prestress.

5. Housing according to Claim 1, characterized in that the lid (18) engages by means of its margin (20) and the projections (24) in a housing groove (13), which is filled with a sealing compound (30).

## Revendications

1. Boîtier électroconducteur (10) pour un appareil électrique (12), en particulier pour un détecteur dans un véhicule automobile, comprenant un couvercle (18) réalisé en une pièce usinée métallique en tôle, qui ferme le boîtier (10) et qui est relié, de façon électroconductrice au boîtier (10), au moyen de saillies (24) en forme de languettes qui se dressent à partir du plan du couvercle (18) constituées au moins par sections sur son bord (20), et dont les extrémités viennent en prise sur une section de paroi (14) du boîtier (10) qui s'étend au moins approximativement à angle droit par rapport au plan du couvercle, le couvercle (18) et le boîtier (10) ayant leurs bords en prise l'un dans l'autre,
caractérisé en ce que
le couvercle (18) est réalisé en une pièce usinée en tôle d'acier et est pourvu sur des sections opposées (22) de son bord (20) de saillies (24) qui sont constituées en forme de crochets et qui viennent en prise dans une rainure (13) en forme d'U du boîtier (10), ouverte du côté du couvercle, les saillies (24) prenant appui sur le fond (27) de la rainure (13) et ayant leurs extrémités en prise par autoblocage sur une section de paroi (14) du boîtier (10) qui délimite latéralement la rainure (13).

2. Boîtier selon la revendication (1),
caractérisé en ce que
la rainure (13) du boîtier (10) fait tout le tour de celui-ci et les saillies (24) du couvercle (18) sont disposées de préférence le long de tout son bord (20), du moins toutefois sur les sections rectilignes (22) du bord (20).

3. Boîtier selon la revendication (1),
caractérisé en ce que
les saillies (24), constituées en forme de crochets, du couvercle (18) se replient en sens contraire du sens de jonction du couvercle (18).

4. Boîtier selon la revendication (1),
caractérisé en ce que
les saillies (24) ont leurs extrémités à bord vif et s'enfoncent du fait de leur précontrainte dans la section de paroi (14) du boîtier (10).

5. Boîtier selon la revendication (1),
caractérisé en ce que
le couvercle (18) vient en prise par son bord (20) et par les saillies (24), dans une rainure du boîtier (13) qui est remplie d'une masse d'étanchéité (30).
